# EUROPÄISCHE PATENTSCHRIFT

(11) **EP 4 008 811 B1**
(45) Veröffentlichungstag und Bekanntmachung des Hinweises auf die Patenterteilung: **06.09.2023**
(21) Anmeldenummer: 21211352.6
(22) Anmeldetag: 30.11.2021
(51) Int. Cl.: C30B 23/00, C30B 23/06, C30B 29/16, C30B 29/36, C30B 29/40

(54) **VERFAHREN ZUR HERSTELLUNG EINES EINKRISTALLS IN EINEM WACHSTUMSTIEGEL**
METHOD FOR PRODUCING A SINGLE CRYSTAL IN A GROWING CRUCIBLE
PROCÉDÉ DE FABRICATION D'UN CRISTAL UNIQUE DANS UN CREUSET DE CROISSANCE

(30) Priorität: 01.12.2020 DE 102020131840
(43) Veröffentlichungstag der Anmeldung: 08.06.2022
(73) Patentinhaber: Friedrich-Alexander-Universität Erlangen-Nürnberg, 91054 Erlangen (DE)
(72) Erfinder: Wellmann, Peter, 90425 Nürnberg (DE)
(74) Vertreter: Louis Pöhlau Lohrentz

(56) Entgegenhaltungen:
- US-A1- 2012 225 004
- WELLMANN ET AL: "Vapor growth of SiC bulk crystals and its challenge of doping", SURFACE AND COATINGS TECHNOLOGY, ELSEVIER, NL, Bd. 201, Nr. 7, 25. November 2006 (2006-11-25), Seiten 4026-4031, XP005729916, ISSN: 0257-8972, DOI: 10.1016/J.SURFCOAT.2006.08.033
- WELLMANN ET AL: "Numerical modeling and experimental verification of modified-PVT crystal growth of SiC", JOURNAL OF CRYSTAL GROWTH, ELSEVIER, AMSTERDAM, NL, Bd. 303, Nr. 1, 10. April 2007 (2007-04-10), Seiten 337-341, XP022025725, ISSN: 0022-0248, DOI: 10.1016/J.JCRYSGRO.2006.11.328
- WELLMANN P ET AL: "SiC single crystal growth by a modified physical vapor transport technique", JOURNAL OF CRYSTAL GROWTH, ELSEVIER, AMSTERDAM, NL, Bd. 275, Nr. 1-2, 15. Februar 2005 (2005-02-15), Seiten e555-e560, XP025371847, ISSN: 0022-0248 [gefunden am 2005-02-15]

## Beschreibung

Die Erfindung betrifft ein Verfahren zur Herstellung eines Einkristalls in einem Wachstumstiegel. Das Verfahren wird insbesondere zur Vergrößerung eines Einkristalls in einem Wachstumstiegel durchgeführt. Weiterhin betrifft die Erfindung einen Wachstumstiegel zur Herstellung und/oder Vergrößerung eines Einkristalls.

Nach dem Stand der Technik werden zahlreiche Einkristalle für die Anwendung in elektronischen Bauelementen oder zur Nutzung als Schmucksteine durch Verdampfen eines Quellenmaterials bei hohen Temperaturen und durch Abscheidung oder Kristallisation an einer etwas kälteren Stelle nach dem sogenannten PVT-Verfahren (englisch für "physical vapor transport") hergestellt. Bei Verfahren nach dem Stand der Technik kommt es aufgrund hoher Temperaturgradienten zu thermisch induzierten Spannungen am wachsenden Einkristall. Thermisch induzierte Spannungen führen zu einer erhöhten Versetzungsdichte. Dies führt insbesondere bei der Herstellung von großen Einkristallen zu Schwierigkeiten.

Nach dem Stand der Technik ist es weiterhin bekannt, dass ein ansonsten geschlossener Wachstumstiegel eine Gaszuführleitung aufweist. Über diese Gaszuführleitung wird dabei ein gasförmiger Dotierstoff dem Gasraum zum Zweck der Dotierung des wachsenden Einkristalls zugeführt. Das dabei durchgeführte Verfahren wird als modifiziertes PVT-Verfahren, oder kurz M-PVT-Verfahren bezeichnet und ist beispielsweise in den deutschen Patentschriften DE 10 2008 063 124 B4 und DE 10 2008 063 129 B4 sowie in P.J. Wellmann et al., "Vapor growth of SiC bulk crystals and its challenge of doping", Surface & Coatings Technology 201 (2006) 4026-4031, beschrieben. Bei den bekannten Verfahren ist die Gasströmung durch die Gaszuführleitung so klein, dass diese keine Störung für das PVT-Verfahren, das heißt insbesondere für das Verdampfen, den Transport und die Abscheidung des Quellenmaterials, bewirkt.

Die US-amerikanische Patentanmeldung US 2012 / 0 225 004 A1 betrifft eine Kristallzüchtungsanlage zur Herstellung von SiC-Kristallen. Bei der bekannten Kristallzüchtungsanlage kann ein Gasgemisch durch einen Gaseinlass in den Wachstumstiegel eingelassen werden und diesen durch die porösen Tiegelwände wieder verlassen.

Aufgabe der vorliegenden Erfindung ist es, die Nachteile aus dem Stand der Technik zu beseitigen. Insbesondere soll ein Verfahren angegeben werden, mit dem die Temperaturgradienten im Wachstumstiegel, insbesondere der axiale Temperaturgradient reduziert werden kann. Dadurch soll insbesondere die Qualität bei der Herstellung von großen Einkristallen verbessert werden. Weiterhin soll ein entsprechender Wachstumstiegel bereitgestellt werden.

Erfindungsgemäß wird diese Aufgabe durch ein Verfahren gemäß dem Gegenstand des Anspruchs 1 und durch einen Wachstumstiegel gemäß dem Gegenstand des Anspruchs 13 gelöst. Vorteilhafte Ausgestaltungen der Erfindung sind dazu jeweils in den abhängigen Ansprüchen angegeben.

Nach Maßgabe der Erfindung wird ein Verfahren zur Herstellung und/oder Vergrößerung eines Einkristalls durch Aufheizen, Verdampfen und Abscheiden eines Quellenmaterials in einem Wachstumstiegel beansprucht.

Der Wachstumstiegel ist vorzugsweise zylinderförmig. Das Quellenmaterial und der Einkristall sind innerhalb des Wachstumstiegels angeordnet. Der Wachstumstiegel weist vorzugsweise einen Tiegelboden unterhalb des Quellenmaterials, eine Tiegelseitenwand und einen Tiegeldeckel oberhalb des Einkristalls auf. Das Innere des Wachstumstiegels weist vorzugsweise eine zylindrische Form oder eine im Wesentlichen zylindrische Form auf. Vorzugsweise sind das Quellenmaterial und der Einkristall an den beiden axial gegenüberliegenden Enden des Inneren des Wachstumstiegels angeordnet. Das Quellenmaterial besteht vorzugsweise aus dem gleichen Material wie der Einkristall. Ein Gasraum ist im Wachstumstiegel zwischen dem Quellenmaterial und dem Einkristall vorgesehen.

Das Quellenmaterial hat vorzugsweise eine im Wesentlichen zylindrische Form. Das Quellenmaterial hat dabei vorzugsweise einen Durchmesser, der dem Innendurchmesser des zylindrischen Wachstumstiegels entspricht. Das Quellenmaterial füllt also vorzugsweise den Wachstumstiegel in radialer Richtung vollständig aus.

Der Einkristall hat vorzugsweise eine im Wesentlichen zylindrische Form, insbesondere die Form eines einseitig konvex abgerundeten Zylinders, wobei die konvex abgerundete Seite des Einkristalls dem Quellenmaterial zugewandt ist. Der Einkristall hat vorzugsweise einen Durchmesser, der im Wesentlichen dem Innendurchmesser des Wachstumstiegels entspricht. Der Einkristall kann dabei insbesondere einen Durchmesser aufweisen, der 60 % bis 100 %, vorzugsweise 75 % bis 95 %, des Innendurchmessers des Wachstumstiegels entspricht. Genauer gesagt kann der einkristalline Bereich des Einkristalls dabei insbesondere einen Durchmesser aufweisen, der 60 % bis 100 %, vorzugsweise 75 % bis 95 %, des Innendurchmessers des Wachstumstiegels entspricht. Der Einkristall kann die Innenseite der Tiegelseitenwand berühren. Alternativ kann der Einkristall ohne direkten Kontakt zur Tiegelseitenwand hergestellt werden. Darüber hinaus kann der Einkristall von einem polykristallinen Ring umgeben sein. Der polykristalline Ring kann an der Innenseite der Tiegelseitenwand anliegen.

Das Quellenmaterial kann insbesondere ein Karbid und/oder ein Nitrid umfassen. Vorzugsweise wird als Quellenmaterial Siliziumkarbid, bzw. als Formel geschrieben SiC, verwendet. Als Quellenmaterial ist vorzugsweise SiC, besonders bevorzugt ein SiC-Pulver und/oder ein SiC-Volumenkörper, vorgesehen. Das SiC-Pulver kann eine Korngröße von 10 µm bis mehreren mm aufweisen. Der SiC-Volumenkörper kann insbesondere polykristallin sein. SiC-Volumenkörper kann ein fester SiC-Zylinderblock sein. Der SiC-Zylinderblock kann offenporig bis hin zu dicht sein. Weiterhin kann der SiC-Volumenkörper und/oder der SiC-Zylinderblock einteilig oder mehrteilig sein.

Alternativ kann beispielsweise Aluminiumnitrid, das heißt AlN, als Quellenmaterial verwendet werden. Vorzugsweise kann dabei ein AlN-Pulver und/oder ein AIN-Volumenkörper, insbesondere ein polykristalliner AIN-Volumenkörper, vorgesehen sein.

Ein weiteres mögliches Quellenmaterial ist Zinkoxid (ZnO). Das Quellenmaterial wird vorzugsweise als Pulver und/oder als massiver Volumenkörper bereitgestellt. Der massive Volumenkörper kann insbesondere polykristallin sein.

Vorzugsweise wird ein zu vergrößernder Einkristall zunächst als Kristallkeim an dem dem Quellenmaterial gegenüberliegenden Ende des Inneren des Wachstumstiegels bereitgestellt. Anstelle des Begriffs "Kristallkeim" könnten auch die Begriffe Keimkristall und/oder Kristallisationskeim verwendet werden. Ausgehend vom Kristallkeim vergrößert sich der Einkristall im Laufe des erfindungsgemäßen Verfahrens durch Anlagerung von durch Verdampfen des Quellenmaterials erzeugtem gasförmigen Vorläufermaterial. Das durch Verdampfen des Quellenmaterials erzeugte gasförmige Vorläufermaterial wird in der vorliegenden Anmeldung auch verkürzt als verdampftes oder als sublimiertes Quellenmaterial bezeichnet. Der Kristallkeim hat vorzugsweise einen Durchmesser, der 60 % bis 100 %, vorzugsweise 75 % bis 95 %, des Innendurchmessers des Wachstumstiegels entspricht. Für einen Durchmesser des Kristallkeims von 150 mm kann beispielsweise der Innendurchmesser des Wachstumstiegels 150 mm bis 200 mm betragen. Der Kristallkeim hat vorzugsweise eine Dicke von ca. 0,5 mm bis 3 mm. Die bevorzugte Dicke beträgt 0,9 bis 1,5 mm. Die Montage des Kristallkeims kann durch eine mechanisch feste Verbindung, vorzugsweise durch Kleben mit einem graphitbasierten Material, auf einer Trägerplatte erfolgen. Die Trägerplatte ist vorzugsweise aus Graphit, aus Tantalkarbid oder aus beschichtetem Graphit, insbesondere aus mit Tantalkarbid beschichtetem Graphit, gebildet. Der Kristallkeim kann an der Trägerplatte fixiert werden. Vorzugsweise wird der Kristallkeim an der Trägerplatte eingehängt. Der Durchmesser des Keimkristalls weist vorzugsweise 85 % bis 120 % des beabsichtigten Durchmessers des einkristallinen Bereiches des hergestellten Einkristalls auf. Bei der geklebten Montage weist der Durchmesser des Keimkristalls vorzugsweise 100 % bis 110% des beabsichtigten Durchmessers des einkristallinen Bereiches des hergestellten Einkristalls auf. Bei der eingehängten Montage weist der Durchmesser des Keimkristalls vorzugsweise 105 % bis 110 % des beabsichtigten Durchmessers des einkristallinen Bereiches des hergestellten Einkristalls auf.

Der Kristallkeim besteht vorzugsweise aus dem gleichen Material wie das Quellenmaterial. Bei der Verwendung von SiC als Quellenmaterial wird als Einkristall ein SiC-Einkristall gebildet. Vorzugsweise wird dabei zur Durchführung des erfindungsgemäßen Verfahrens zunächst ein SiC-Einkristall als Kristallkeim an dem Quellenmaterial gegenüberliegenden Ende des Inneren des Wachstumstiegels vorgesehen. Während der Durchführung des erfindungsgemäßen Verfahrens wird der SiC-Einkristall vergrößert. Dabei wächst der SiC-Einkristall vorzugsweise in axialer Richtung.

Bei der Verwendung von AIN als Quellenmaterial wird als Einkristall ein AIN-Einkristall gebildet. Vorzugsweise wird dabei zur Durchführung des erfindungsgemäßen Verfahrens zunächst ein AlN-Einkristall als Kristallkeim an dem Quellenmaterial gegenüberliegenden Ende des Inneren des Wachstumstiegels vorgesehen. Während der Durchführung des erfindungsgemäßen Verfahrens wird der AIN-Einkristall vergrößert. Dabei wächst der AIN-Einkristall vorzugsweise in axialer Richtung.

Alternativ kann der Kristallkeim aus einem anderen Material als das Quellenmaterial bestehen. Bei der Verwendung von AIN als Quellenmaterial kann beispielsweise als Kristallkeim alternativ ein SiC-Einkristall bereitgestellt werden.

Der Wachstumstiegel weist eine das Quellenmaterial durchgreifende Gaszuführleitung auf. Die Gaszuführleitung verläuft vorzugsweise entlang der Symmetrieachse des zylinderförmigen Wachstumstiegels. Eine Gasströmung wird durch die Gaszuführleitung in den Gasraum eingestellt. Ein Temperaturgradient, vorzugsweise ein axialer Temperaturgradient, wird im Gasraum durch eine Beheizung eingestellt. Die Gasströmung und der Temperaturgradient werden gesteuert. Eine Konvektion wird durch die Gasströmung in Richtung und Stärke bestimmt. Dabei wird vom Quellenmaterial verdampftes Material durch die Konvektion zum Einkristall geführt. Die Gasströmung wird durch einen Diffusor umgeleitet, so dass die Konvektion vorzugsweise derart durch den Diffusor eingestellt wird, dass der Materialtransport vom Quellenmaterial zum Einkristall zu zumindest 50% in einem radial außenliegenden Bereich des Gasraums erfolgt.

In der vorliegenden Anmeldung wird die Gasströmung, das heißt die durch die Gaszuführleitung zugeführte Gasströmung, auch als zugeführte Gasströmung oder als zugeführtes Gas bezeichnet. Das der Konvektion unterliegende Gas wird einfach als Gas bezeichnet.

Im Sinne der vorliegenden Anmeldung ist die Konvektion eine erzwungene Konvektion. Vorzugsweise ist dabei der Einfluss des durch die Beheizung eingestellten Temperaturgradienten auf die Konvektion vernachlässigbar.

Im Sinne der vorliegenden Anmeldung kann anstelle des vorgenannten Temperaturgradienten auch eine Mehrzahl von Temperaturgradienten eingestellt werden. Die Erläuterungen zu der vorliegenden Erfindung nehmen zwar hauptsächlich Bezug auf den Temperaturgradienten bzw. auf die Temperaturgradienten. Dabei versteht es sich aber von selbst, dass es sich um Temperaturgradienten im dreidimensionalen Inneren des Wachstumstiegels handelt. Tatsächlich soll im Rahmen der vorliegenden Erfindung das dreidimensionale Temperaturfeld bzw. das dreidimensionale Temperaturgradientenfeld im Inneren des Wachstumstiegels eingestellt werden und dadurch optimiert werden. Die Temperaturgradienten lassen sich in axiale und radiale Temperaturgradienten unterscheiden. Genauer gesagt, weisen die Temperaturgradienten eine axiale und/oder eine radiale Komponente auf.

Der Temperaturgradient wird vorzugsweise derart eingestellt, dass das Quellenmaterial eine höhere Temperatur aufweist als der Einkristall. Die Temperatur am Quellenmaterial ist vorzugsweise so hoch, dass Quellenmaterial verdampft wird. Die niedrigere Temperatur am Einkristall bewirkt vorzugsweise eine Übersättigung des verdampften Quellenmaterials am Einkristall, so dass es zu einer Abscheidung des verdampften Quellenmaterials am Einkristall kommt.

Vorteilhafterweise erfolgt der Stofftransport, das heißt der Transport des verdampften Quellenmaterials zum Einkristall, durch die Konvektion. Vorteilhafterweise wird der Stofftransport also durch die zugeführte Gasströmung in Richtung und Stärke bestimmt. Daher ist der Temperaturgradient vorteilhafterweise nicht zur Bereitstellung des Stofftransports erforderlich. Vorteilhafterweise ist lediglich ein geringer Temperaturgradient im wachsenden Einkristall erforderlich, um die Kristallisationswärme von der Kristallwachstumsfront abzuführen. Der Temperaturgradient, insbesondere der axiale Temperaturgradient, kann vorteilhafterweise derart eingestellt werden, dass ein Temperaturunterschied zwischen Quellenmaterial und Einkristall möglichst gering ist.

Vorzugweise wird der Stofftransport zu zumindest 70%, bevorzugt zu zumindest 90% durch die zugeführte Gasströmung bereitgestellt. Besonders bevorzugt wird der Stofftransport im Wesentlichen durch die zugeführte Gasströmung bereitgestellt.

Vorteilhafterweise kann also der Temperaturgradient, insbesondere der axiale Temperaturgradient, aufgrund der Bereitstellung des Stofftransports durch die Konvektion reduziert und/oder minimiert werden. Dadurch können vorteilhafterweise thermisch induzierte Spannungen reduziert werden. Dadurch werden vorteilhafterweise Versetzungen vermieden. Die Defektdichte wird also reduziert. Dadurch kann vorteilhafterweise die Qualität bei der Herstellung von großen Einkristallen verbessert und die Lebensdauer in mit diesen Einkristallen ausgestatteten Bauelemente erhöht werden.

Das erfindungsgemäße Verfahren eignet sich also insbesondere für die Herstellung großer Einkristalle, beispielsweise Einkristalle mit einem Durchmesser von 150 mm, 200 mm, 250 mm, 300 mm oder mit einem noch größeren Durchmesser, insbesondere aus SiC oder AlN. Der Durchmesser des Einkristalls beträgt daher beim erfindungsgemäßen Wachstumstiegel bzw. beim erfindungsgemäßen Verfahren vorzugsweise 100 mm bis 300 mm, besonders bevorzugt 150 mm, 200 mm, 250 mm oder 300 mm. Der Durchmesser des Wachstumstiegels übertrifft den Durchmesser des Einkristalls vorzugsweise um 1 mm bis 150 mm.

Die vorliegende Erfindung ist nicht auf das PVT-Verfahren beschränkt, sondern kann bei allen Gasphasenwachstumsprozessen zum Einsatz kommen. Die vorliegende Erfindung kann beispielsweise bei Prozessen zum Einsatz kommen, bei denen Gase als Präkursoren zugeführt werden. Die vorliegende Erfindung kann also z. B. bei der chemischen Gasphasenabscheidung (CVD) zum Einsatz kommen.

Nach Maßgabe der Erfindung wird außerdem ein Wachstumstiegel zur Herstellung und/oder Vergrößerung eines Einkristalls durch Aufheizen, Verdampfen und Abscheiden eines Quellenmaterials, insbesondere durch das erfindungsgemäße Verfahren zur Herstellung und/oder Vergrößerung eines Einkristalls beansprucht. Das Quellenmaterial und der Einkristall sind innerhalb des Wachstumstiegel angeordnet. Der Wachstumstiegel weist einen Tiegelboden unterhalb des Quellenmaterials, eine Tiegelseitenwand und einen Tiegeldeckel oberhalb des Einkristalls auf. Ein Gasraum ist im Wachstumstiegel zwischen dem Quellenmaterial und dem Einkristall vorgesehen. Der Gasraum ist seitlich durch die Tiegelseitenwand begrenzt. Der Wachstumstiegel weist eine den Tiegelboden und das Quellenmaterial durchgreifende Gaszuführleitung zum Zuführen eines Gases in den Gasraum auf. Die Gaszuführleitung weist eine Einströmöffnung im Bereich einer Oberfläche des Quellenmaterials auf. Der Wachstumstiegel weist einen im Gasraum und/oder in der Einströmöffnung, vorzugsweise im Gasraum im Bereich der Einströmöffnung, angeordneten Diffusor zum Umleiten des zugeführten Gases auf. Die Tiegelseitenwand weist eine Permeabilität für das zugeführte Gas und/oder zumindest eine Öffnung zum Ausströmen des zugeführten Gases auf.

Der Wachstumstiegel ist vorzugsweise aus Graphit und/oder Tantalkarbid gebildet. Der Wachstumstiegel kann dabei ausschließlich aus Graphit, ausschließlich aus Tantalkarbid oder aus einer Kombination beider Materialien gebildet sein, beispielsweise aus Tantalkarbid-beschichtetem Graphit.

Der Wachstumstiegel ist vorzugsweise Bestandteil einer Kristallzüchtungsanlage. Die Kristallzüchtungsanlage umfasst einen Rezipienten, den Wachstumstiegel, eine Isolation, eine Beheizung, eine Temperaturmessung, eine Gas-/Vakuum-Einheit und/oder eine Computer-basierte Ablaufsteuerung.

Der Rezipient kann (A) als Edelstahl-Autoklav realisiert werden oder besteht (B) vorzugsweise aus einem zylinderförmigen Quarzglas und einem Edelstahl-Boden und Edelstahl-Deckel-Flansch. Die Kühlung des Quarzglases kann entweder luftgekühlt oder wassergekühlt ausgeführt werden. Im Fall der luftgekühlten Ausführung wird vorzugsweise ein einwandiges Quarzglas verwendet. Im Fall der wassergekühlten Ausführung wird vorzugsweise eine doppelwandige Anordnung mit Innenzylinder aus Quarzglas und Außenzylinder aus Quarzglas, Duran-Glas, Fensterglas, Kunststoff oder Faserverbundwerkstoff verwendet. Die Flansche werden vorzugsweise wassergekühlt.

Die Isolation ist vorzugsweise aus Graphitfilz, aus Graphitfaserstoffen und/oder aus porösem Graphit gebildet. Die Isolation kann ausschließlich aus einem dieser Materialien bestehen oder aus einer Kombination dieser Materialien gebildet sein.

Die Beheizung ist vorzugsweise als Widerstandsbeheizung oder induktiv ausgeführt und weist vorzugsweise mindestens eine Heizzone auf. Weitere Heizzonen sind zur Verbesserung des Temperaturfeldes möglich.
Die Temperaturmessung kann ein oder mehrere hochtemperatur-stabile Thermoelemente oder vorzugsweise ein oder mehrere optische Pyrometer, vorzugsweise Quotienten-Pyrometer, umfassen.

Die Gas-/Vakuum-Einheit ist vorzugsweise dazu ausgestaltet, auf der Eingangsseite des Rezipienten verschiedene Prozessgase, wie Argon, Helium und Stickstoff kontrolliert über Massenflussregler einzuleiten. Auf der Ausgangsseite befindet sich vorzugsweise ein regelbares Abgasventil, z.B. ein Schmetterlingsventil, an das ein Vakuumpumpensystem aus einer Vorvakuumpumpe, beispielsweise einer Membran- oder Drehschieberpumpe mit einem End-Druck p von typischerweise p < 10⁻³ mbar, und optional einer nachgeschalteten Hochvakuumpumpe, beispielsweise einer Turbomolekularpumpe mit einem End-Druck p < 10⁻⁵ bis 10⁻⁷ mbar, angeschlossen ist.

Die Computer-basierte Ablaufsteuerung ist vorzugsweise dazu ausgestaltet, die Kontrolle des Prozesses über (i) die Messung der Temperatur(en) und (ii) des Gasdrucks im Rezipienten, sowie über (iii) die Steuerung der Heizleistung, (iv) der Gasflüsse und (v) des regelbaren Abgas-Ventils zu übernehmen. Dabei verwendet die Computer-basierte Ablaufsteuerung vorzugsweise Temperatur-, Gasdruck und/oder Gasfluss-Zeitprofile.

Die oben in Bezug auf das erfindungsgemäße Verfahren erläuterten zusätzlichen Merkmale und Vorteile können ebenso auf den erfindungsgemäßen Wachstumstiegel bezogen werden. Die nachfolgend besprochenen vorteilhaften Ausgestaltungen der Erfindung können gleichweise auf das erfindungsgemäße Verfahren und/oder auf den erfindungsgemäßen Wachstumstiegel bezogen werden.

Nach einer vorteilhaften Ausgestaltung der Erfindung wird die Konvektion in Form einer Ringwalze ausgebildet. Die Ringwalze ist vorzugsweise symmetrisch zur Symmetrieachse des zylinderförmigen Wachstumstiegels. Vorzugsweise erstreckt sich die Ringwalze über den gesamten Gasraum im Wachstumstiegel. Der Drehsinn der Ringwalze kann so beschaffen sein, dass das zugeführte Gas zusammen mit verdampftem Quellenmaterial entlang der Symmetrieachse des zylinderförmigen Wachstumstiegels aufsteigt und im Bereich der Tiegelseitenwand abfällt. In diesem Fall trifft das zugeführte Gas mit dem verdampften Quellenmaterial mittig auf den wachsenden Einkristall und bewegt sich von dort aus radial nach außen. Alternativ dazu kann der Drehsinn der Ringwalze so beschaffen sein, dass das zugeführte Gas zusammen mit dem verdampften Quellenmaterial im Bereich der Tiegelseitenwand aufsteigt und entlang der Symmetrieachse des zylinderförmigen Wachstumstiegels abfällt. In diesem Fall trifft das zugeführte Gas mit dem verdampften Quellenmaterial auf den wachsenden Einkristall in dessen Peripherie und bewegt sich von dort aus radial nach innen.

Die Gasströmung nimmt vorzugsweise keinen chemischen Einfluss auf den Wachstumsprozess des Einkristalls. Nach einer weiteren vorteilhaften Ausgestaltung der Erfindung ist die Gasströmung aus einem oder mehreren Inertgasen, vorzugsweise Helium, Argon und/oder Stickstoff gebildet. Anders ausgedrückt ist dabei also das zugeführte Gas aus einem oder mehreren Inertgasen, vorzugsweise Helium, Argon und/oder Stickstoff gebildet. Im Fall von SiC als Quellenmaterial und/oder Einkristall ist Stickstoff ein Dotierstoff, genauer gesagt ein n-Typ Dotierstoff, das heißt ein Donator. Daher ist Stickstoff in diesem Fall nicht als Inertgas einzustufen. Eine zu hohe Stickstoffdotierung stört in diesem Fall das Kristallwachstum. Daher wird Stickstoff vorzugsweise allenfalls als Zugabe zu einem Hauptstrom aus Helium oder Argon hinzugefügt.

Vorzugsweise weist das die Gasströmung bildende Inertgas eine hinreichend große Atommasse auf. Dadurch erfolgt vorteilhafterweise ein effektiver Transport des verdampften Quellenmaterials. Argon weist eine Atommasse von etwa 40 u auf. Daher weist die Gasströmung vorzugsweise Argon als Bestandteil auf. Stickstoff weist ein Konvektionsverhalten vergleichbar zu Argon auf.

Weiterhin weist das die Gasströmung bildende Inertgas vorzugsweise eine hohe Permeationsrate durch dichten Graphit auf. Dadurch kann vorteilhafterweise sichergestellt werden, dass bei entsprechender Ausgestaltung des Wachstumstiegels mit einer Tiegelseitenwand aus dichtem Graphit ein hinreichend großer Austrag aus dem Wachstumstiegel erfolgt und dass damit der Druck im Wachstumstiegel trotz weiteren Zuführens von Inertgas begrenzt bleibt. Helium weist eine besonders hohe Permeationsrate durch dichten Graphit auf. Daher bildet Helium vorzugsweise den Hauptbestandteil der Gasströmung.

Vorzugsweise wird die Gasströmung aus Helium als Hauptbestandteil mit einem Zusatz von Argon gebildet. Der Anteil von Helium liegt dabei vorzugsweise bei zumindest 75 %.

Nach einer weiteren vorteilhaften Ausgestaltung der Erfindung weist die Gasströmung einen Gasfluss in einem Bereich von 5 bis 700 sccm auf. Vorzugsweise weist die Gasströmung einen Gasfluss in einem Bereich von 15 bis 500 sccm auf und besonders bevorzugt einen Gasfluss in einem Bereich von 50 bis 350 sccm auf. Die angegebenen Werte sind vorzugsweise auf einen Durchmesser des Einkristalls von 150 mm bezogen. Bei einem derart bemessenen Gasfluss kann verdampftes Quellenmaterial besonders effektiv transportiert werden. Weiterhin ermöglicht ein derart bemessener Gasfluss vorteilhafterweise ein besonders gleichmäßiges Wachstum des Einkristalls. Vorzugsweise wird der Gasfluss der Gasströmung an die Kristallwachstumsrate angepasst. Dabei hat der Drehsinn der Ringwalze Einfluss auf die vorzusehende lokale Kristallwachstumsrate und damit auf den Gasfluss der Gasströmung. Ist der Drehsinn der Ringwalze so beschaffen, dass das Inertgas zusammen mit verdampftem Quellenmaterial entlang der Symmetrieachse des zylinderförmigen Wachstumstiegels aufsteigt und im Bereich der Tiegelseitenwand abfällt, wird der Gasfluss der Gasströmung vorzugsweise derart an die Kristallwachstumsrate angepasst, insbesondere begrenzt, dass eine Vertiefung mit geringerer Wachstumsrate im Rotationszentrum des Einkristalls verhindert wird. Dazu wird vorzugsweise eine hinreichend große Menge an sublimiertem Quellenmaterial in die Konvektion eingekoppelt.

Vorteilhafterweise folgt die Wachstumsphasengrenze dadurch einer regelmäßigen, leicht konvexen Oberfläche.

Nach einer weiteren vorteilhaften Ausgestaltung der Erfindung wird der Temperaturgradient derart eingestellt, dass ein Temperaturunterschied zwischen Quellenmaterial und Einkristall in einem Bereich von 5 °C und 100 °C, vorzugsweise in einem Bereich von 10 °C und 30 °C liegt. Der Temperaturgradient wird also vorzugsweise möglichst klein eingestellt. Dadurch können vorteilhafterweise thermisch induzierte Spannungen reduziert werden. Dadurch werden vorteilhafterweise Versetzungen vermieden und damit die Defektdichte reduziert. Vorteilhafterweise wird dadurch die Qualität bei der Herstellung von großen Einkristallen verbessert. Dadurch kann die Lebensdauer in mit diesen Einkristallen ausgestatteten Bauelementen erhöht werden.

Nach Maßgabe der Erfindung weist der Wachstumstiegel einen im Gasraum und/oder in der Einströmöffnung, vorzugsweise im Gasraum im Bereich der Einströmöffnung, angeordneten Diffusor zum Umleiten des zugeführten Gases auf.

Nach Maßgabe der Erfindung wird die Gasströmung durch den Diffusor umgeleitet. Der Diffusor ist vorzugsweise im Gasraum und/oder in der Einströmöffnung angeordnet, besonders bevorzugt im Gasraum im Bereich der Einströmöffnung. Vorzugsweise führt das Vorsehen des Diffusors zu einer Umkehrung der Richtung der Konvektion, das heißt zu einer Umkehrung des Drehsinns der Ringwalze. Der Drehsinn der Ringwalze ist vorzugsweise dabei so beschaffen, dass das zugeführte Gas, insbesondere Inertgas, zusammen mit verdampftem Quellenmaterial im Bereich der Tiegelseitenwand aufsteigt und entlang der Symmetrieachse des zylinderförmigen Wachstumstiegels abfällt. Das Inertgas mit dem verdampften Quellenmaterial trifft also auf den wachsenden Einkristall in dessen Peripherie und bewegt sich von dort aus radial nach innen.

Vorzugsweise wird die Konvektion durch den Diffusor derart eingestellt, dass der Materialtransport vom Quellenmaterial zum Einkristall zu zumindest 50%, vorzugsweise zu zumindest 75%, bevorzugt zu zumindest 90%, besonders bevorzugt im Wesentlichen, in einem radial außenliegenden Bereich des Gasraums erfolgt. Unter im Wesentlichen wird ein Prozentsatz von mehr als 90%, vorzugsweise von mehr als 95% verstanden. Unter dem radial außenliegenden Bereich wird die äußere Hälfte des Radius des Gasraums, vorzugsweise das äußere Drittel des Radius des Gasraums, besonders bevorzugt das äußere Viertel des Radius des Gasraums verstanden.

Vorzugsweise wird der Gasfluss der Gasströmung an die Kristallwachstumsrate angepasst. Aufgrund der Richtungsumkehr trifft das Inertgas zusammen mit dem verdampften Quellenmaterial also nicht zentral auf den Einkristall. Daher kann die Kristallwachstumsrate deutlich höher als im oben beschriebenen Fall ohne diese Richtungsumkehr eingestellt werden. Die Menge an verdampftem Quellenmaterial, welches in die Konvektion eingekoppelt wird, ist vorzugsweise so groß, dass es im radial außenliegenden Bereich des Einkristalls, in dem das zusammen mit dem verdampften Quellenmaterial aufsteigende Inertgas den Einkristall erreicht, zu regulärem Wachstum kommt. Vorzugsweise folgt die Wachstumsphasengrenze einer regelmäßigen, leicht konvexen Oberfläche.

Vorzugsweise ist der Diffusor trichterförmig ausgestaltet. Ein trichterförmig ausgestalteter Diffusor verteilt die Gasströmung vorteilhafterweise in Umfangsrichtung besonders gleichmäßig und ermöglicht somit ein in Umfangsrichtung möglichst gleichmäßiges Einströmen des Inertgases in den Gasraum. Der Diffusor kann beispielsweise als ein trichterförmiger Deckel der Gaszuführleitung ausgestaltet sein. Die Gaszuführleitung kann dazu in den Gasraum des Wachstumstiegels hinein verlängert sein und seitliche Öffnungen aufweisen, aus denen das Inertgas radial nach außen hin austreten kann.

Die dem Einkristall zugewandte Oberseite des Diffusors kann flach ausgeführt sein. Vorzugsweise ist der Emissionsgrad der Oberfläche an der Oberseite des Diffusors an den Emissionsgrad der Oberfläche des Quellenmaterials angepasst, um Inhomogenitäten des Wärmetransports im Gasraum zu vermeiden.

Alternativ dazu kann die dem Einkristall zugewandte Oberseite des Diffusors ebenfalls eine trichterförmige Ausgestaltung aufweisen. Die zusätzliche Trichterform verteilt vorteilhafterweise das entlang der Symmetrieachse des Wachstumstiegels nach unten strömende Gas gleichmäßig radial nach außen. Vorzugsweise wird die geometrische Ausgestaltung der Oberseite des Diffusors derart vorgenommen, dass ein eingeprägtes Oberflächenprofil die emittierte und/oder reflektierte Wärmestrahlung im Gasraum des Wachstumstiegels nicht negativ beeinflusst. Vorteilhafterweise kann dadurch eine Erhöhung des radialen Temperaturgradienten an der Kristallwachstumsfront verhindert werden.

Vorzugsweise weist der Wachstumstiegel einen Tiegelboden unterhalb des Quellenmaterials, eine Tiegelseitenwand und einen Tiegeldeckel oberhalb des Einkristalls auf. Nach einer weiteren vorteilhaften Ausgestaltung der Erfindung ist die Tiegelseitenwand für das zugeführte Gas teilweise durchlässig. Bei dem zugeführten Gas handelt es sich insbesondere um Inertgas. Vorzugsweise weist die Tiegelseitenwand dazu eine Permeabilität für das zugeführte Gas und/oder zumindest eine Öffnung zum Ausströmen des zugeführten Gases auf. Zum Bereitstellen einer Permeabilität ist die Tiegelseitenwand beispielsweise aus einem dichten Graphit gebildet. Dichte Graphite sind insbesondere für die Inertgase Helium, Argon und Stickstoff permeabel. Alternativ oder ergänzend weist die Tiegelseitenwand vorzugsweise kleine Öffnungen auf, die ein Ausströmen des zugeführten Gases ermöglichen.

Durch die durchlässige Tiegelseitenwand kann ein Teil des zugeführten Gases, das heißt insbesondere des Inertgases, radial nach außen aus dem Wachstumstiegel ausgeleitet werden. Somit kann eine Anreicherung des zugeführten Gases im Wachstumstiegel und damit ein ungewollter Druckanstieg vorteilhafterweise verhindert werden. Vorzugsweise wird die durch die Gaszuführleitung pro Zeitraum zugeführte Menge an Gas, insbesondere an Inertgas, über die Tiegelseitenwand im gleichen Zeitraum auch wieder ausgeleitet.

Vorteilhafterweise werden unter Ausnutzung der Gaspermeabilität von dichten Graphiten die zugeführten Gase das heißt insbesondere die Inertgase, selektiv ausgekoppelt. Das verdampfte Quellenmaterial wird hingegen an der Tiegelseitenwand aus Graphit blockiert oder geht chemische Reaktionen ein. Vorzugsweise verlässt das verdampfte Quellenmaterial den Wachstumstiegel nicht.

Im Fall einer für die Inertgase impermeablen Tiegelseitenwand, z.B. dicht gesintertes Tantalkarbid, sind vorzugsweise kleine Öffnungen in der Tiegelseitenwand vorgesehen. Die Öffnungen sind jedoch nicht selektiv hinsichtlich der zugeführten Gase. Daher kann es in diesem Fall zu einem Verlust an verdampftem Quellenmaterial aus dem Wachstumstiegel kommen.

Nach einer weiteren vorteilhaften Ausgestaltung der Erfindung weist ein an den Tiegeldeckel angrenzender Abschnitt der Tiegelseitenwand eine im Vergleich zur übrigen Tiegelseitenwand erhöhte Durchlässigkeit für das zugeführte Gas auf. Bei dem zugeführten Gas handeln es sich insbesondere um Inertgas. Die erhöhte Durchlässigkeit kann durch eine erhöhte Permeabilität und/oder durch das Vorsehen der zumindest einen Öffnung bereitgestellt sein. Vorzugsweise weist der an den Tiegeldeckel angrenzende Abschnitt der Tiegelseitenwand also die eine im Vergleich zur übrigen Tiegelseitenwand erhöhte Permeabilität für das zugeführte Gas, das heißt insbesondere für das Inertgas, und/oder die zumindest eine Öffnung auf. Der an den Tiegeldeckel angrenzender Abschnitt der Tiegelseitenwand kann auch als ein am oberen Ende der Tiegelseitenwand angeordneter Abschnitt bezeichnet werden. Der Abschnitt ist vorzugsweise ringförmig. Beispielsweise ist der an den Tiegeldeckel angrenzende Abschnitt der Tiegelseitenwand aus weniger dichtem Graphit, beispielsweise aus porösem Graphit gebildet. Die Porosität beträgt vorzugsweise 50 % bis 90 %, besonders bevorzugt 65 % bis 75 %, beispielsweise ca. 70 %. Der an den Tiegeldeckel angrenzende Abschnitt der Tiegelseitenwand kann ein auf die übrige Tiegelseitenwand aufgesetztes separates Element sein.

Nach einer weiteren vorteilhaften Ausgestaltung der Erfindung wird eine Teilströmung aus der Konvektion abgezweigt und durch den an den Tiegeldeckel angrenzenden Abschnitt der Tiegelseitenwand geführt wird, so dass durch die Teilströmung ein Kontakt des wachsenden Einkristalls mit der Tiegelseitenwand verhindert wird. Somit weist die die Konvektion bildende Ringwalze vorzugsweise einen Zufluss aus Gaszuführleitung und einen Abfluss durch den an den Tiegeldeckel angrenzenden Abschnitt der Tiegelseitenwand auf.

Vorzugsweise wird die Teilströmung, insbesondere ein Teil des Inertgases, radial nach außen durch den an den Tiegeldeckel angrenzenden Abschnitt der Tiegelseitenwand aus dem Wachstumstiegel ausgeleitet. Durch die erhöhte Durchlässigkeit am oberen Ende der Tiegelseitenwand gelangt das im radial außenliegenden Bereich des Gasraums aufsteigende Gas, insbesondere Inertgas, vorzugsweise in einen den Einkristall radial umgebenden Ringraum, so dass in diesem Ringraum das Kristallwachstum unterdrückt wird. Damit wird vorteilhafterweise ein Anwachsen des Einkristalls an die Tiegelseitenwand verhindert. Der Einkristall wächst vorteilhafterweise ohne Kontakt zur Tiegelseitenwand.

Durch das zur Tiegelseitenwand kontaktfreie Wachstum werden vorteilhafterweise thermische Spannungen im Einkristall reduziert. Derartige thermische Spannungen entstehen insbesondere beim Abkühlen des Wachstumstiegels am Ende des Wachstumsprozesses. Dabei schrumpft das Tiegelmaterial, beispielsweise Graphit, aufgrund seines größeren thermischen Ausdehnungskoeffizienten stärker als der Einkristall. Dadurch übt die Tiegelseitenwand einen mechanischen Druck auf den Einkristall aus. Dieser mechanische Druck wird also vorteilhafterweise durch das zur Tiegelseitenwand kontaktfreie Wachstum vermieden.

Das Vorsehen des an den Tiegeldeckel angrenzenden Abschnitts mit erhöhter Durchlässigkeit für die Inertgase am oberen Ende der Tiegelseitenwand verhindert vorteilhafterweise zudem die Anreicherung des zugeführten Inertgases im Wachstumstiegel und einen dadurch verursachten ungewollten Druckanstieg.

Im Fall einer für die Inertgase impermeablen Tiegelseitenwand, z.B. dicht gesintertes Tantalkarbid, sind vorzugsweise kleine Öffnungen im an den Tiegeldeckel angrenzenden Abschnitt der Tiegelseitenwand vorgesehen. Vorzugsweise sind an der übrigen Tiegelseitenwand keine, kleinere und/oder weniger Öffnungen als in diesem Abschnitt vorgesehen. Die Öffnungen sind jedoch nicht selektiv hinsichtlich der Gase. Daher kann es in diesem Fall zu einem Verlust an verdampftem Quellenmaterial aus dem Wachstumstiegel kommen.

Nach einer weiteren vorteilhaften Ausgestaltung der Erfindung ist die Gaszuführleitung aus Graphit und/oder aus Tantalkarbid gebildet. Die Gaszuführleitung kann insbesondere ausschließlich aus Graphit, aus Graphit mit Innen- und/oder Außenbeschichtung aus Tantalkarbid, oder ausschließlich aus Tantalkarbid gebildet sein. Vorzugsweise ist die Gaszuführleitung aus dem gleichen Material wie der Wachstumstiegel gebildet.

Nach einer weiteren vorteilhaften Ausgestaltung der Erfindung weist die Gaszuführleitung einen Außendurchmesser von 5 mm bis 30 mm, vorzugsweise von 10 mm bis 20 mm auf.

Nach einer weiteren vorteilhaften Ausgestaltung der Erfindung weist die Gaszuführleitung eine Wandstärke von 0,5 mm bis 5 mm, vorzugsweise von 1,5 mm bis 3 mm bei einer Gaszuführleitung aus Graphit oder 0,5 mm bis 2 mm bei einer Gaszuführleitung aus Tantalkarbid auf.

Die Erfindung wird nun anhand von Ausführungsbeispielen näher erläutert. Es zeigen:
- Fig. 1: eine schematische Darstellung eines Wachstumstiegels nach dem Stand der Technik,
- Fig. 2: eine schematische Darstellung eines ersten nicht zur Erfindung gehörenden Wachstumstiegels,
- Fig. 3: eine schematische Darstellung eines zweiten erfindungsgemäßen Wachstumstiegels,
- Fig. 4: eine schematische Darstellung eines dritten erfindungsgemäßen Wachstumstiegels.

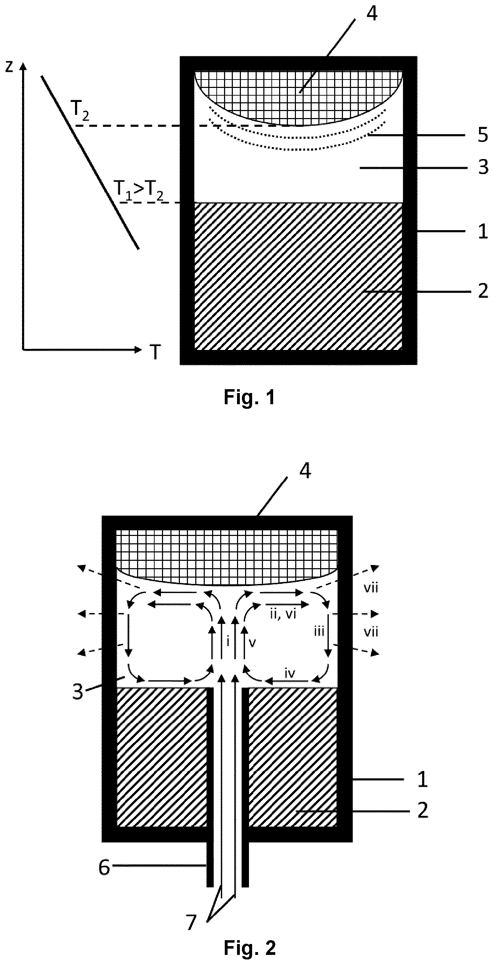

Fig. 1 zeigt eine schematische Darstellung eines Wachstumstiegels nach dem Stand der Technik. Der zylindrische Wachstumstiegel weist eine Tiegelwand 1 auf. Die Tiegelwand 1 gliedert sich in einen Tiegelboden, eine Tiegelseitenwand und einen Tiegeldeckel. Im Inneren des Wachstumstiegels sind ein Quellenmaterial 2, ein Gasraum 3 und ein Einkristall 4 aufgenommen. Das Quellenmaterial 2 und der Einkristall 4 sind an den beiden axial gegenüberliegenden Enden des Inneren des Wachstumstiegels angeordnet und dabei durch den Gasraum 3 voneinander getrennt. Das Quellenmaterial 2 hat eine im Wesentlichen zylindrische Form. Der Einkristall 4 hat die Form eines einseitig konvex abgerundeten Zylinders. Das Quellenmaterial 2 ist beispielsweise ein Pulver aus Siliziumkarbid (in Formelschreibweise SiC). Als Einkristall 4 wird entsprechend ein Einkristall aus SiC hergestellt.

Der Wachstumstiegel wird zur Vergrößerung des Einkristalls 4 so aufgeheizt, dass Quellenmaterial 2 durch Sublimation in die Gasphase übergeht, als gasförmiges Vorläufermaterial durch den Gasraum transportiert wird und am Einkristall 4 auskristallisiert.

Dem Wachstumstiegel ist schematisch der Verlauf der Temperatur T in z-Richtung, das heißt in Axialrichtung des Wachstumstiegels gegenübergestellt. Die Temperatur an der an den Gasraum 3 angrenzenden Grenzfläche des Quellenmaterials 2 beträgt T₁. Die Grenzfläche des Quellenmaterials 2 ist vorzugsweise eben oder im Wesentlichen eben. Vorzugsweise ist die Temperatur entlang der Grenzfläche des Quellenmaterials 2 konstant. Die Grenzfläche des Quellenmaterials 2 liegt also vorzugsweise auf einer Isothermen mit der Temperatur T₁. Die Temperatur T₁ ist ausreichend hoch eingestellt, dass es zu einer Sublimation von Quellenmaterial 2 kommt. Die Temperatur an der an den Gasraum 3 angrenzenden Grenzfläche des Einkristalls 4 beträgt T₂. Diese Grenzfläche des Einkristalls 4 hat eine konvexe Form und kann auch als Wachstumsgrenzfläche bezeichnet werden. Vorzugsweise ist die Temperatur entlang der konvexen Wachstumsgrenzfläche konstant. Die Wachstumsgrenzfläche ist also vorzugsweise entlang einer Isotherme mit der Temperatur T₂ ausgebildet. Die Temperatur T₂ ist kleiner als die Temperatur T_{1.} Zwischen dem Quellenmaterial 2 und dem Einkristall 4 ist also ein axialer Temperaturgradient ausgebildet. Die Temperatur T₂ ist so eingestellt, dass es zu einer Übersättigung des gasförmigen Vorläufermaterials, insbesondere zu einer Übersättigung der Wachstumsspezies, und dadurch zu einer Kristallisation am Einkristall 4 kommt. Das Quellenmaterial 2 wird durch die Sublimation fortwährend verbraucht. Der Einkristall 4 wird durch die Kristallisation fortwährend vergrößert. Vorzugsweise bildet sich die Wachstumsgrenzfläche dabei beständig entlang einer Isotherme. Exemplarisch sind zwei weitere Isothermen in Figur 1 schematisch innerhalb des Gasraums 3 eingezeichnet und mit dem Bezugszeichen 5 versehen. Die beiden an diesen Isothermen vorhandenen Temperaturen übersteigen jeweils die Temperatur T₂.

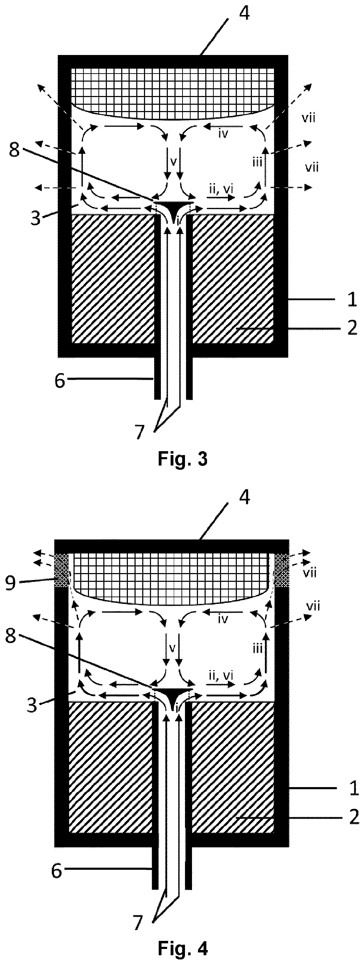

Die Figur 2 zeigt eine schematische Darstellung eines ersten nicht zur Erfindung gehörenden Wachstumstiegels. Die Figuren 3 und 4 zeigen jeweils schematische Darstellungen eines ersten bis dritten erfindungsgemäßen Wachstumstiegels. Der Wachstumstiegel weist in allen Ausführungsformen der Erfindung jeweils alle beschriebenen Elemente und Eigenschaften des Wachstumstiegels aus Fig. 1 auf. Zusätzlich weist der Wachstumstiegel jeweils eine Gaszuführleitung 6 auf. Die Gaszuführleitung 6 durchgreift den Tiegelboden und das Quellenmaterial 2. Die Gaszuführleitung 6 weist eine Einströmöffnung im Bereich der an den Gasraum 3 angrenzenden Oberfläche des Quellenmaterials auf. Mit Hilfe der Gaszuführleitung 6 ist es möglich, eine Gasströmung 7 einzustellen, die durch die Gaszuführleitung 6 in den Gasraum 3 zugeführt wird. Die zugeführte Gasströmung 7 kann aus einem oder mehreren Inertgasen gebildet sein. Beispielsweise ist die zugeführte Gasströmung 7 aus einem Gemisch von Helium und Argon gebildet.

Zusätzlich ist die Tiegelseitenwand des ersten Wachstumstiegels und des zweiten und dritten erfindungsgemäßen Wachstumstiegels gemäß den Figuren 2 bis 4 jeweils so beschaffen, dass ein Teil des zugeführten Inertgases den Gasraum 3 durch ein Hindurchtreten durch die Tiegelseitenwand verlässt. Die Tiegelseitenwand kann dazu eine Permeabilität für das zugeführte Inertgas aufweisen. Die Tiegelseitenwand kann beispielsweise aus dichtem Graphit gebildet sein, so dass sie eine Permeabilität für die Inertgase Helium und Argon aufweist. Alternativ oder ergänzend kann die Tiegelseitenwand zumindest eine Öffnung zum Ausleiten des zugeführten Inertgases aufweisen.

Fig. 2 zeigt eine schematische Darstellung des ersten nicht zur Erfindung gehörenden Wachstumstiegels. Die durch die Gaszuführleitung 6 zugeführte Gasströmung 7 erzeugt eine erzwungene Konvektion im Gasraum 3. Die erzwungene Konvektion bildet sich dabei in Form einer Ringwalze aus. Nachfolgend wird die erzwungene Konvektion anhand der Fig. 2 als eine Abfolge der Schritte bzw. Abschnitte (i) bis (vi) beschrieben. Zusätzlich steht ein Schritt bzw. Abschnitt (vii) für das Hindurchtreten des Inertgases durch die Tiegelseitenwand.

Die durch die Gaszuführleitung 6 zugeführte Gasströmung 7 bewirkt ein weiteres Aufsteigen des zugeführten Inertgases im Gasraum 3 (i). Das Inertgas teilt sich vor der Wachstumsphasengrenze im rotationssymmetrischen, insbesondere zylindrischen, Wachstumstiegel trichterförmig nach außen auf (ii), fällt vor der Tiegelseitenwand nach unten (iii), läuft parallel zur Oberfläche des Quellenmaterials 2 nach innen und reißt dabei sublimierendes Quellenmaterial 2 mit sich (iv). Im Fall von SiC als Quellenmaterial reißt das Inertgas also sublimierende SiC-Gasspezies mit sich. Dabei handelt es sich im Wesentlichen um die Gaskomponenten Si, Si₂C und SiC₂. Beim Wiederaufstieg im Rotationszentrum des Wachstumstiegels trägt das Inertgas das sublimierte Quellenmaterial 2, das heißt im gezeigten Beispiel die SiC-Gasspezies, nach oben (v). Nach der trichterförmigen Auffächerung trägt das Inertgas das sublimierte Quellenmaterial 2 entlang der Wachstumsphasengrenze radial nach außen. Dabei kommt es zu einer Abscheidung des sublimierten Quellenmaterials 2 an der Wachstumsphasengrenze und dadurch zum Wachstum des Einkristalls 4. Im hier gezeigten Beispiel kommt es zu einer Abscheidung der SiC-Gasspezies und dadurch zum Wachstum des SiC-Einkristalls (vi).

Die Menge an im Schritt bzw. Abschnitt (i) zugeführtem Inertgas wird vorteilhafterweise an die Kristallwachstumsrate angepasst. Die Menge an sublimiertem Quellenmaterial 2, welches im Schritt bzw. Abschnitt (iv) in die erzwungene Konvektion eingekoppelt wird, ist vorteilhafterweise so groß, dass es im Rotationszentrum des Einkristalls 4 zu regulärem Wachstum kommt. Dadurch folgt die Wachstumsphasengrenze einer regelmäßigen, leicht konvexen Oberfläche. Dadurch wird verhindert, dass der Einkristall 4 im Rotationszentrum eine Vertiefung mit geringerer Wachstumsrate aufweist.

Damit es zu keiner Anreicherung des zugeführten Inertgases im Wachstumstiegel und dadurch zu einem ungewollten Druckanstieg kommt, wird ein Teil des Inertgases radial nach außen durch die Tiegelseitenwand aus dem Wachstumstiegel ausgeleitet (vii). Das Ausleiten erfolgt durch kleine Öffnungen in der Tiegelseitenwand und/oder unter Ausnutzung der Permeabilität von dichten Graphiten für das verwendete Inertgas, das heißt im gezeigten Beispiel Helium und/oder Argon.

Die pro Zeitraum im Schritt bzw. Abschnitt (i) zugeführte Menge an Inertgas wird vorteilhafterweise über die Tiegelseitenwand im gleichen Zeitraum auch wieder ausgeleitet.

Die zugeführte Menge, das heißt der zugeführte Gasfluss an Inertgas, insbesondere an Helium, beträgt in diesem Beispiel 5 sccm bis 100 sccm, bevorzugt 15 sccm bis 50 sccm. Eine Begrenzung des Gasflusses erfolgt durch den zentralen Punkt des wachsenden Einkristalls, um eine Kraterbildung zu verhindern.

Vorteilhafterweise verlässt dabei das sublimierte Quellenmaterial 2, das heißt im gezeigten Beispiel die SiC-Gasspezies, den Wachstumstiegel nicht. Durch Ausnutzung der Gaspermeabilität von dichten Graphiten werden die Inertgase selektiv ausgekoppelt, im gezeigten Beispiel Helium und Argon. Die SiC-Gasspezies werden an der Tiegelseitenwand aus Graphit blockiert oder gehen chemische Reaktionen ein. Dadurch bleiben die SiC-Gasspezies innerhalb des Wachstumstiegels.

Im Fall einer für die Inertgase impermeablen Tiegelseitenwand, z.B. dicht gesintertes Tantalkarbid, sind kleine Öffnungen in der Tiegelseitenwand vorgesehen, vorzugsweise in einem oberen Bereich der Seitenwand. Die Öffnungen sind jedoch nicht selektiv hinsichtlich der Inertgase. Daher kommt es in diesem Fall zu einem Verlust an SiC-haltigen Gasspezies aus dem Wachstumstiegel.

Fig. 3 zeigt eine schematische Darstellung des zweiten erfindungsgemäßen Wachstumstiegels. Die durch die Gaszuführleitung 6 zugeführte Gasströmung 7 erzeugt auch beim zweiten erfindungsgemäßen Wachstumstiegel eine erzwungene Konvektion im Gasraum 3, die sich in Form einer Ringwalze ausbildet. Der zweite erfindungsgemäßen Wachstumstiegel weist die gleichen Merkmale auf wie der erste erfindungsgemäße Wachstumstiegel. Zusätzlich ist beim zweiten erfindungsgemäßen Wachstumstiegel ein Diffusor 8 im Gasraum im Bereich der Einströmöffnung angeordnet. Der Diffusor 8 leitet das zugeführte Inertgas um. Dadurch kommt es im Vergleich zum ersten erfindungsgemäßen Wachstumstiegel zu einer Richtungsumkehr der erzwungenen Konvektion.

In den gezeigten Ausführungsbeispielen ist der Diffusor 8 als ein trichterförmiger Deckel der Gaszuführleitung 6 ausgestaltet. Die Gaszuführleitung 6 ist dazu in den Gasraum 3 des Wachstumstiegels hinein verlängert und weist seitliche Öffnungen auf, aus denen das Inertgas radial nach außen hin austreten kann. Die Trichterform des Diffusor 8 ermöglicht vorteilhafterweise ein in Umfangsrichtung möglichst gleichmäßiges Einströmen des Inertgases in den Gasraum 3.

Nachfolgend wird die erzwungene Konvektion für den zweiten erfindungsgemäßen Wachstumstiegel anhand der Fig. 3 als eine Abfolge der Schritte bzw. Abschnitte (i) bis (vi) beschrieben. Zusätzlich steht ein Schritt bzw. Abschnitt (vii) für das Hindurchtreten des Inertgases durch die Tiegelseitenwand.

Der Diffusor 8 bewirkt eine Umlenkung der durch die Gaszuführleitung 6 zugeführte Gasströmung 7 auf Höhe der dem Einkristall 4 zugewandten Oberfläche des Quellenmaterials 2 um 90°. Das Inertgas teilt sich dabei trichterförmig auf (i). Das Inertgas wird radialsymmetrisch nach außen in den Gasraum 3 eingeleitet. Dabei bewegt sich das Inertgas entlang der Oberfläche des Quellenmaterials 2 radial von innen nach außen und reißt dabei sublimierendes Quellenmaterial 2 mit sich (ii). Im Fall von SiC als Quellenmaterial 2 reißt das Inertgas sublimierende SiC-Gasspezies mit sich. Dabei handelt es sich im Wesentlichen um die Gaskomponenten Si, Si₂C und SiC₂. Das Inertgas steigt zusammen mit dem sublimierten Quellenmaterial 2 an der Tiegelseitenwand noch oben (iii), bewegt sich entlang der Wachstumsphasengrenze radial von außen nach innen (iv). Dabei kommt es zu einer Abscheidung des sublimierten Quellenmaterials 2 an der Wachstumsphasengrenze und dadurch zum Wachstum des Einkristalls 4. Im hier gezeigten Beispiel kommt es zu einer Abscheidung der SiC-Gasspezies und dadurch zum Wachstum des SiC-Einkristalls. Im Rotationszentrum des Wachstumstiegels fällt das Inertgas wie in einen Trichter hinein nach unten (v) und bewegt sich wieder entlang der Oberfläche des Quellenmaterials 2 von innen nach außen und reißt erneut sublimierendes Quellenmaterial 2 mit sich (vi).

Die Menge an im Schritt bzw. Abschnitt (i) zugeführtem Inertgas wird auch beim zweiten erfindungsgemäßen Wachstumstiegel vorteilhafterweise an die Kristallwachstumsrate angepasst. Die Kristallwachstumsrate kann dabei aber deutlich höher als beim ersten erfindungsgemäßen Wachstumstiegel eingestellt werden, weil das zugeführte Inertgas nicht wie bei diesem zentral auf den Einkristall 4 trifft. Die Menge an sublimiertem Quellenmaterial 2, welches im Schritt bzw. Abschnitt (ii) in die erzwungene Konvektion eingekoppelt wird, ist vorteilhafterweise so groß, dass es im radial außenliegenden Bereich des Einkristalls 4, in dem das zusammen mit dem sublimierten Quellenmaterial 2 im Schritt bzw. Abschnitt (iii) aufsteigende Inertgas den Einkristall 4 erreicht, zu regulärem Wachstum kommt. Dadurch folgt die Wachstumsphasengrenze einer regelmäßigen, leicht konvexen Oberfläche.

Damit es auch beim zweiten erfindungsgemäßen Wachstumstiegel zu keiner Anreicherung des zugeführten Inertgases im Wachstumstiegel und dadurch wiederum zu einem ungewollten Druckanstieg kommt, wird ein Teil des Inertgases radial nach außen durch die Tiegelseitenwand aus dem Wachstumstiegel ausgeleitet (vii). Das Ausleiten erfolgt wieder durch kleine Öffnungen in der Tiegelseitenwand und/oder unter Ausnutzung der Permeabilität von dichten Graphiten für das verwendete Inertgas, das heißt im gezeigten Beispiel Helium und/oder Argon.

Die zugeführte Menge, das heißt der zugeführte Gasfluss an Inertgas, insbesondere an Helium, beträgt in diesem Beispiel 15 sccm bis 700 sccm, bevorzugt, 45 sccm bis 350 sccm, besonders bevorzugt 90 sccm bis 270 sccm.

Für das Ausleiten eines Teils des Inertgases durch die Tiegelseitenwand gelten im Übrigen die bereits oben für den ersten erfindungsgemäßen Wachstumstiegel beschriebenen Aspekte. Zur Vermeidung von Wiederholungen wird daher auf die Ausführungen zum ersten erfindungsgemäßen Wachstumstiegel verwiesen.

Fig. 4 zeigt eine schematische Darstellung des dritten erfindungsgemäßen Wachstumstiegels. Der dritte erfindungsgemäße Wachstumstiegel weist die bereits für den ersten und zweiten erfindungsgemäßen Wachstumstiegel beschriebenen Merkmale auf. Insbesondere weist der dritte erfindungsgemäße Wachstumstiegel auch einen Diffusor 8 auf. Daher erzeugt die durch die Gaszuführleitung 6 zugeführte Gasströmung 7 eine erzwungene Konvektion im Gasraum 3, die sich in Form einer Ringwalze mit einem Drehsinn wie beim zweiten erfindungsgemäßen Wachstumstiegel ausbildet. Die bereits zu Fig. 3 beschriebene Abfolge der Schritte bzw. Abschnitte (i) bis (vi) gilt gemäß Fig. 4 ebenso für den dritten erfindungsgemäßen Wachstumstiegel.

Abweichend zum zweiten erfindungsgemäßen Wachstumstiegel weist die Tiegelseitenwand beim dritten erfindungsgemäßen Wachstumstiegel an ihrem oberen Ende einen ringförmigen Abschnitt 9 mit erhöhter Durchlässigkeit für das Inertgas, das heißt im gezeigten Beispiel Helium und/oder Argon, auf. Ein Teil des Inertgases wird radial nach außen durch den ringförmigen Abschnitt 9 der Tiegelseitenwand aus dem Wachstumstiegel ausgeleitet (vii). Die erhöhte Durchlässigkeit kann durch eine erhöhte Permeabilität und/oder das Vorsehen kleiner Öffnungen bereitgestellt sein. Durch die erhöhte Durchlässigkeit am oberen Ende der Tiegelseitenwand gelangt das beim Schritt bzw. Abschnitt (iii) aufsteigende Inertgas in einen radial den Einkristall 4 umgebenden Ringraum, so dass in diesem Ringraum das Kristallwachstum unterdrückt wird. Damit wird ein Anwachsen des Einkristalls an die Tiegelseitenwand verhindert. Der Einkristall 4 wächst also ohne Kontakt zur Tiegelseitenwand.

Durch das zur Tiegelseitenwand kontaktfreie Wachstum werden vorteilhafterweise thermische Spannungen im Einkristall 4 reduziert. Derartige thermische Spannungen entstehen insbesondere beim Abkühlen des Wachstumstiegels am Ende des Wachstumsprozesses. Dabei schrumpft beispielsweise das Tiegelmaterial Graphit aufgrund seines größeren thermischen Ausdehnungskoeffizienten stärker als der Einkristall 4, der im gezeigten Beispiel aus SiC gebildet wird. Dadurch übt die Tiegelseitenwand einen mechanischen Druck auf den Einkristall 4 aus. Dieser mechanische Druck wird also vorteilhafterweise durch das zur Tiegelseitenwand kontaktfreie Wachstum beim dritten erfindungsgemäßen Wachstumstiegel vermieden.

Das Vorsehen des ringförmigen Abschnitts 9 mit erhöhter Durchlässigkeit für die Inertgase am oberen Ende der Tiegelseitenwand verhindert vorteilhafterweise zudem die Anreicherung des zugeführten Inertgases im Wachstumstiegel und einen dadurch verursachten ungewollten Druckanstieg.

Zusätzlich weist die Tiegelseitenwand auch beim dritten erfindungsgemäßen Wachstumstiegel - wie bereits schon für den ersten und zweiten erfindungsgemäßen Wachstumstiegel beschrieben - in ihrem an den Gasraum 3 angrenzenden Abschnitt eine Durchlässigkeit für das Inertgas auf. Ein Teil des Inertgases wird radial nach außen durch die Tiegelseitenwand aus dem Wachstumstiegel ausgeleitet (vii). Dadurch wird eine Anreicherung des zugeführten Inertgases im Wachstumstiegel und damit ein ungewollter Druckanstieg verhindert. Das Ausleiten erfolgt auch hier wiederum durch kleine Öffnungen in der Tiegelseitenwand und/oder unter Ausnutzung der Permeabilität von dichten Graphiten für das verwendete Inertgas.

Die zugeführte Menge, das heißt der zugeführte Gasfluss an Inertgas, insbesondere an Helium, beträgt in diesem Beispiel 200 sccm bis 700 sccm, bevorzugt 300 sccm bis 500 sccm.

Für das Ausleiten eines Teils des Inertgases durch die Tiegelseitenwand gelten im Übrigen die bereits oben für den ersten und zweiten erfindungsgemäßen Wachstumstiegel beschriebenen Aspekte. Zur Vermeidung von Wiederholungen wird daher auf die Ausführungen zum ersten und zweiten erfindungsgemäßen Wachstumstiegel verwiesen.

Die dem Einkristall 4 zugewandte Oberseite des Diffusors 8 ist in den gezeigten Ausführungsbeispielen flach ausgeführt. Der Emissionsgrad der Oberfläche an der Oberseite des Diffusors 8 ist an den Emissionsgrad der Oberfläche des Quellenmaterials 2 angepasst, um Inhomogenitäten des Wärmetransports im Gasraum zu vermeiden.

In einem weiteren, nicht in den Figuren dargestellten Ausführungsbeispiel weist die dem Einkristall 4 zugewandte Oberseite des Diffusors 8 ebenfalls eine trichterförmige Ausgestaltung auf. Die zusätzliche Trichterform verteilt vorteilhafterweise das beim Schritt bzw. Abschnitt (v) (gemäß Fig. 3 oder Fig. 4) nach unten strömende Inertgas gleichmäßig radial nach außen. Vorzugsweise wird die geometrische Ausgestaltung der Oberseite des Diffusors 8 derart vorgenommen, dass das eingeprägte Oberflächenprofil die emittierte und/oder reflektierte Wärmestrahlung im Gasraum 3 des Wachstumstiegels nicht negativ beeinflusst. Beispielsweise kann dadurch eine Erhöhung des radialen Temperaturgradienten an der Kristallwachstumsfront verhindert werden.

### Bezugszeichenliste

- 1: Tiegelwand
- 2: Quellenmaterial
- 3: Gasraum
- 4: Einkristall
- 5: Isothermen
- 6: Gaszuführleitung
- 7: Gasströmung
- 8: Diffusor
- 9: ringförmiger Abschnitt mit erhöhter Durchlässigkeit

## Patentansprüche

1. Verfahren zur Herstellung und/oder Vergrößerung eines Einkristalls
durch Aufheizen, Verdampfen und Abscheiden eines Quellenmaterials in einem Wachstumstiegel,
wobei das Quellenmaterial und der Einkristall innerhalb des Wachstumstiegels angeordnet sind,
wobei ein Gasraum im Wachstumstiegel zwischen dem Quellenmaterial und dem Einkristall vorgesehen ist,
wobei der Wachstumstiegel eine das Quellenmaterial durchgreifende Gaszuführleitung aufweist, wobei eine Gasströmung durch die Gaszuführleitung in den Gasraum eingestellt wird,
wobei ein Temperaturgradient im Gasraum durch eine Beheizung eingestellt wird,
wobei die Gasströmung und der Temperaturgradient gesteuert werden,
wobei eine Konvektion durch die Gasströmung in Richtung und Stärke bestimmt wird, wobei vom Quellenmaterial verdampftes Material durch die Konvektion zum Einkristall geführt wird, und wobei die Gasströmung durch einen Diffusor umgeleitet wird, so dass die Konvektion vorzugsweise derart durch den Diffusor eingestellt wird, dass der Materialtransport vom Quellenmaterial zum Einkristall zu zumindest 50% in einem radial außenliegenden Bereich des Gasraums erfolgt.

2. Verfahren nach Anspruch 1, wobei die Konvektion in Form einer Ringwalze ausgebildet wird.

3. Verfahren nach Anspruch 1 oder 2, wobei die Gasströmung aus einem oder mehreren Inertgasen, vorzugsweise Helium, Argon und/oder Stickstoff gebildet ist.

4. Verfahren nach einem der vorangehenden Ansprüche, wobei die Gasströmung einen Gasfluss in einem Bereich von 5 bis 700 sccm aufweist, vorzugsweise einen Gasfluss in einem Bereich von 15 bis 500 sccm aufweist und besonders bevorzugt einen Gasfluss in einem Bereich von 50 bis 350 sccm aufweist.

5. Verfahren nach einem der vorangehenden Ansprüche, wobei der Temperaturgradient derart eingestellt wird, dass ein Temperaturunterschied zwischen Quellenmaterial und Einkristall in einem Bereich von 5 °C und 100 °C, vorzugsweise in einem Bereich von 10 °C und 30 °C liegt.

6. Verfahren nach einem der vorangehenden Ansprüche, wobei die Konvektion derart durch den Diffusor eingestellt wird, dass der Materialtransport vom Quellenmaterial zum Einkristall zu zumindest 75%, bevorzugt zu zumindest 90%, besonders bevorzugt im Wesentlichen, in einem radial außenliegenden Bereich des Gasraums erfolgt.

7. Verfahren nach einem der vorangehenden Ansprüche, wobei der Wachstumstiegel einen Tiegelboden unterhalb des Quellenmaterials, eine Tiegelseitenwand und einen Tiegeldeckel oberhalb des Einkristalls aufweist, wobei die Tiegelseitenwand für das zugeführte Gas teilweise durchlässig ist, wobei die Tiegelseitenwand vorzugsweise eine Permeabilität für das zugeführte Gas und/oder zumindest eine Öffnung zum Ausströmen des zugeführten Gases aufweist.

8. Verfahren nach einem der vorangehenden Ansprüche, wobei ein an den Tiegeldeckel angrenzender Abschnitt der Tiegelseitenwand eine im Vergleich zur übrigen Tiegelseitenwand erhöhte Durchlässigkeit für das zugeführte Gas aufweist.

9. Verfahren nach Anspruch 8, wobei eine Teilströmung aus der Konvektion abgezweigt wird und durch den an den Tiegeldeckel angrenzenden Abschnitt der Tiegelseitenwand geführt wird, so dass durch die Teilströmung ein Kontakt des wachsenden Einkristalls mit der Tiegelseitenwand verhindert wird.

10. Verfahren nach einem der vorangehenden Ansprüche, wobei die Gaszuführleitung aus Graphit und/oder aus Tantalkarbid gebildet ist.

11. Verfahren nach einem der vorangehenden Ansprüche, wobei die Gaszuführleitung einen Außendurchmesser von 5 mm bis 30 mm, vorzugsweise von 10 mm bis 20 mm aufweist.

12. Verfahren nach einem der vorangehenden Ansprüche, wobei die Gaszuführleitung eine Wandstärke von 0,5 mm bis 5 mm, vorzugsweise von 1,5 mm bis 3 mm bei einer Gaszuführleitung aus Graphit oder 0,5 mm bis 2 mm bei einer Gaszuführleitung aus Tantalkarbid aufweist.

13. Wachstumstiegel zur Herstellung und/oder Vergrößerung eines Einkristalls durch Aufheizen, Verdampfen und Abscheiden eines Quellenmaterials, insbesondere durch ein Verfahren zur Herstellung und/oder Vergrößerung eines Einkristalls nach einem der Ansprüche 1 bis 12,
wobei das Quellenmaterial und der Einkristall innerhalb des Wachstumstiegel angeordnet sind,
wobei der Wachstumstiegel einen Tiegelboden unterhalb des Quellenmaterials, eine Tiegelseitenwand und einen Tiegeldeckel oberhalb des Einkristalls aufweist,
wobei ein Gasraum im Wachstumstiegel zwischen dem Quellenmaterial und dem Einkristall vorgesehen ist, wobei der Gasraum seitlich durch die Tiegelseitenwand begrenzt ist,
wobei der Wachstumstiegel eine den Tiegelboden und das Quellenmaterial durchgreifende Gaszuführleitung zum Zuführen eines Gases in den Gasraum aufweist, wobei die Gaszuführleitung eine Einströmöffnung im Bereich einer Oberfläche des Quellenmaterials aufweist,
wobei der Wachstumstiegel einen im Gasraum und/oder in der Einströmöffnung, vorzugsweise im Gasraum im Bereich der Einströmöffnung, angeordneten Diffusor zum Umleiten des zugeführten Gases aufweist,
und wobei die Tiegelseitenwand eine Permeabilität für das zugeführte Gas und/oder zumindest eine Öffnung zum Ausströmen des zugeführten Gases aufweist.

## Claims

1. Method for producing and/or enlarging a single crystal by heating, evaporating and precipitating a source material in a growth crucible,
wherein the source material and the single crystal are arranged inside the growth crucible,
wherein a gas chamber is provided in the growth crucible between the source material and the single crystal,
wherein the growth crucible has a gas supply line going through the source material,
wherein a gas stream into the gas chamber through the gas supply line is regulated,
wherein a temperature gradient in the gas chamber is regulated by heating,
wherein the gas stream and the temperature gradient are controlled,
wherein a convection is determined by the gas stream in terms of direction and strength, wherein material evaporated from the source material is guided by the convection to the single crystal, and wherein the gas stream is redirected through a diffuser so that the convection is preferably regulated by the diffuser such that at least 50% of the transport of material from the source material to the single crystal occurs in a radially external region of the gas chamber.

2. Method according to claim 1, wherein the convection is formed in the form of a ring roller.

3. Method according to claim 1 or 2, wherein the gas stream is formed from one or more inert gases, preferably helium, argon and/or nitrogen.

4. Method according to one of the preceding claims, wherein the gas stream has a gas flow rate in a range of 5 to 700 sccm, preferably has a gas flow rate in a range of 15 to 500 sccm, and especially preferably has a gas flow rate in a range of 50 to 350 sccm.

5. Method according to one of the preceding claims, wherein the temperature gradient is regulated such that a temperature difference between source material and single crystal lies in a range of 5°C and 100°C, preferably in a range of 10°C and 30°C.

6. Method according to one of the preceding claims, wherein the convection is regulated by the diffuser such that at least 75%, preferably at least 90%, especially preferably almost all of the transport of material from the source material to the single crystal occurs in a radially external region of the gas chamber.

7. Method according to one of the preceding claims, wherein the growth crucible has a crucible base underneath the source material, a crucible side wall and a crucible lid above the single crystal, wherein the crucible side wall is partially permeable for the supplied gas, wherein the crucible side wall preferably has a permeability for the supplied gas and/or at least one opening to discharge the supplied gas.

8. Method according to one of the preceding claims, wherein a section of the crucible side wall that adjoins the crucible lid has an increased permeability for the supplied gas in comparison to the remaining crucible side wall.

9. Method according to claim 8, wherein a partial stream is diverted from the convection and is guided through the section of the crucible side wall that adjoins the crucible lid, so that contact of the growing single crystal with the crucible side wall is prevented by the partial stream.

10. Method according to one of the preceding claims, wherein the gas supply line is formed from graphite and/or from tantalum carbide.

11. Method according to one of the preceding claims, wherein the gas supply line has an exterior diameter of 5mm to 30mm, preferably of 10mm to 20mm.

12. Method according to one of the preceding claims, wherein the gas supply line has a wall thickness of 0.5mm to 5mm, preferably of 1.5mm to 3mm in a gas supply line made of graphite, or 0.5mm to 2mm in a gas supply line made of tantalum carbide.

13. Growth crucible for producing and/or enlarging a single crystal by heating, evaporating and precipitating a source material, in particular by a method for producing and/or enlarging a single crystal according to one of claims 1 to 12, wherein the source material and the single crystal are arranged inside the growth crucible,
wherein the growth crucible has a crucible base underneath the source material, a crucible side wall and a crucible lid above the single crystal,
wherein a gas chamber is provided in the growth crucible between the source material and the single crystal, wherein the gas chamber is delimited on the side by the crucible side wall,
wherein the growth crucible has a gas supply line that goes through the crucible base and the source material to guide a gas into the gas chamber, wherein the gas supply line has an inlet opening in the region of a surface of the source material,
wherein the growth crucible has a diffuser arranged in the gas chamber and/or in the inlet opening, preferably in the gas chamber in the region of the inlet opening, to redirect the supplied gas,
and wherein the crucible side wall has a permeability for the supplied gas and/or at least one opening to discharge the supplied gas.

## Revendications

1. Procédé de fabrication et/ou d'agrandissement d'un monocristal par chauffage, évaporation et dépôt d'un matériau source dans un creuset de croissance,
dans lequel le matériau source et le monocristal sont disposés à l'intérieur du creuset de croissance,
dans lequel un compartiment à gaz est prévu dans le creuset de croissance entre le matériau source et le monocristal,
dans lequel le creuset de croissance comprend une conduite d'alimentation en gaz traversant le matériau source, dans lequel un flux de gaz à travers la conduite d'alimentation en gaz dans le compartiment à gaz est réglé,
dans lequel un gradient de température est réglé dans le compartiment à gaz à l'aide d'un chauffage,
dans lequel le flux de gaz et le gradient de température sont contrôlés,
dans lequel une convection est déterminée, en ce qui concerne la direction et l'intensité, par le flux de gaz, dans lequel le matériau évaporé du matériau source est guidé par convection vers le monocristal et dans lequel le flux de gaz est dévié par un diffuseur de sorte que la convection est de préférence réglée par le diffuseur de façon à ce que le transport de matériau du matériau source vers le monocristal a lieu à hauteur d'au moins 50 % dans une zone radialement externe du compartiment à gaz.

2. Procédé selon la revendication 1, dans lequel la convection présente la forme d'un rouleau annelé.

3. Procédé selon la revendication 1 ou 2, dans lequel le flux de gaz est constitué d'un ou plusieurs gaz inertes, de préférence de l'hélium, de l'argon et/ou de l'azote.

4. Procédé selon l'une des revendications précédentes, dans lequel le flux de gaz présente un débit de gaz de 5 à 700 sccm, de préférence un débit de gaz de 15 à 500 sccm et plus particulièrement de préférence un débit de gaz de 50 à 350 sccm.

5. Procédé selon l'une des revendications précédentes, dans lequel le gradient de température est réglé de sorte qu'une différence de température entre le matériau source et le monocristal se trouve dans une plage entre 5 °C et 100 °C, de préférence dans une plage entre 10 °C et 30 °C.

6. Procédé selon l'une des revendications précédentes, dans lequel la convection est réglée par le diffuseur de sorte que le transport de matériau du matériau source vers le monocristal a lieu à hauteur d'au moins 75 %, de préférence d'au moins 90 %, plus particulièrement de préférence globalement, dans une zone radialement externe du compartiment à gaz.

7. Procédé selon l'une des revendications précédentes, dans lequel le creuset de croissance comprend un fond de creuset en dessous du matériau source, une paroi latérale de creuset et un couvercle de creuset au-dessus du monocristal, dans lequel la paroi latérale du creuset est partiellement perméable au gaz introduit, dans lequel la paroi latérale du creuset présente, de préférence, une perméabilité au gaz introduit et/ou au moins une ouverture pour la sortie du gaz introduit.

8. Procédé selon l'une des revendications précédentes, dans lequel une portion de la paroi latérale du creuset, adjacente au couvercle du creuset, présente une perméabilité au gaz introduit supérieure en comparaison avec le reste de la paroi latérale du creuset.

9. Procédé selon la revendication 8, dans lequel un flux partiel est dévié de la convection et est guidé à travers la portion de la paroi latérale du creuset, adjacente au couvercle du creuset, de sorte que le flux partiel empêche un contact du monocristal en croissance avec la paroi latérale du creuset.

10. Procédé selon l'une des revendications précédentes, dans lequel la conduite d'alimentation en gaz est constituée de graphite et/ou de carbure de tantale.

11. Procédé selon l'une des revendications précédentes, dans lequel la conduite d'alimentation en gaz présente un diamètre extérieur de 5 mm à 30 mm, de préférence de 10 mm à 20 mm.

12. Procédé selon l'une des revendications précédentes, dans lequel la conduite d'alimentation en gaz présente une épaisseur de paroi de 0,5 mm à 5 mm, de préférence de 1,5 mm à 3 mm pour une conduite en graphite ou de 0,5 mm à 2 mm pour une conduite d'alimentation en gaz en carbure de tantale.

13. Creuset de croissance pour la fabrication et/ou l'agrandissement d'un monocristal par chauffage, évaporation et dépôt d'un matériau source, plus particulièrement à l'aide d'un procédé de fabrication et/ou d'agrandissement d'un monocristal selon l'une des revendications 1 à 12,
dans lequel le matériau source et le monocristal sont disposés à l'intérieur du creuset de croissance,
dans lequel le creuset de croissance comprend un fond de creuset en dessous du matériau source, une paroi latérale de creuset et un couvercle de creuset au-dessus du monocristal,
dans lequel un compartiment à gaz est prévu dans le creuset de croissance entre le matériau source et le monocristal, dans lequel le compartiment à gaz est délimité latéralement par la paroi latérale du creuset,
dans lequel le creuset de croissance comprend une conduite d'alimentation en gaz traversant le fond du creuset et le matériau source, pour l'introduction d'un gaz dans le compartiment à gaz, dans lequel la conduite d'alimentation en gaz comprend une ouverture d'entrée au niveau de la surface du matériau source,
dans lequel le creuset de croissance comprend un diffuseur disposé dans le compartiment de gaz et/ou dans l'ouverture d'entrée, de préférence dans le compartiment à gaz au niveau de l'ouverture d'entrée, pour la déviation du gaz introduit,
et dans lequel la paroi latérale du creuset présente une perméabilité au gaz introduit et/ou au moins une ouverture pour la sortie du gaz introduit.
